# DEMANDE DE BREVET EUROPEEN

(11) **EP 4 811 999 A1**
(43) Date de publication de la demande: **23.09.2026**
(21) Numéro de dépôt: 26163449.7
(22) Date de dépôt: 10.03.2026
(51) Int. Cl.: H10P 58/00

(54) **PUCE ELECTRONIQUE A BASE DE NITRURE DE GALLIUM**

(30) Priorité: 19.03.2025 FR 2502770
(71) Demandeur: STMicroelectronics International N.V., 1228 Plan-les-Ouates, Geneva (CH)
(72) Inventeur: CONSTANT, Aurore, 37100 Tours (FR); AVERTIN, Sebastien, 37320 Esvres (FR); LE GALL, Pascal, 37390 Cerelles (FR); SAMA, Nossikpendou Yves, 37100 Tours (FR); TRINGALI, Cristina, 96011 Augusta (IT); PIZZARDI, Antonio Filippo Massimo, 95045 Misterbianco (IT); IUCOLANO, Ferdinando, 95030 Gravina di Catania (IT)
(74) Mandataire: Cabinet Beaumont

(57) **Abrégé**

La présente description concerne un procédé de fabrication de puces électroniques comportant les étapes successives suivantes :
a) former une structure d'interconnexion (13) sur une face supérieure d'un empilement à base de nitrure de gallium (15), lui-même disposé sur une face supérieure d'un substrat semiconducteur (11) ;
b) disposer une première couche (30) sur la face supérieure de la structure (13) ;
c) former un masque de gravure en résine sur la face supérieure de la première couche (30) puis graver la première couche (30) et la structure (13) à travers le masque de gravure dans une région périphérique de chaque puce jusqu'à dévoiler la face supérieure de l'empilement (15) ;
d) graver l'empilement (15) en vis-à-vis de ladite région périphérique en utilisant la première couche (30) comme masque de gravure, jusqu'à dévoiler la face supérieure du substrat (11) ;
e) individualiser les puces électroniques.

## Description

### Domaine technique

La présente description concerne de façon générale le domaine des puces électroniques et plus particulièrement le domaine des puces électroniques à base de nitrure de gallium.

### Technique antérieure

Dans l'industrie, la plupart des dispositifs électroniques sont fabriqués par série. Plusieurs puces électroniques sont ainsi usuellement fabriquées dans et sur un même substrat semiconducteur, par exemple une même plaque ou une tranche semiconductrice. Les puces électroniques peuvent ensuite être séparées, ou individualisées, pour pouvoir être utilisées, par exemple seules ou dans un dispositif électronique comportant d'autres composants. Cette individualisation est généralement réalisée par découpe, par exemple au moyen d'une scie.

Lors de cette individualisation, par exemple lors d'une découpe d'une plaquette semiconductrice, une fissure peut se former sur un bord d'une puce électronique et se propager dans la puce. Une telle fissure peut conduire à une défaillance des circuits électroniques de la puce électronique.

Pour protéger une puce électronique, en particulier lors de la fabrication, de l'individualisation, ou lors de l'utilisation, la puce électronique peut inclure, au niveau de sa périphérie, des moyens d'arrêt des fissures.

Il serait souhaitable de pallier au moins en partie à certains inconvénients des réalisations connues des puces électroniques.

### Résumé de l'invention

Pour cela, un mode de réalisation prévoit un procédé de fabrication de puces électroniques comportant les étapes successives suivantes :
a) former une structure d'interconnexion sur une face supérieure d'un empilement à base de nitrure de gallium, lui-même disposé sur une face supérieure d'un substrat semiconducteur ;
b) disposer une première couche isolante sur la face supérieure de la structure d'interconnexion ;
c) former un masque de gravure en résine sur la face supérieure de la première couche isolante puis graver la première couche isolante et la structure d'interconnexion à travers le masque de gravure en résine dans une région périphérique de chaque puce électronique jusqu'à dévoiler la face supérieure de l'empilement à base de nitrure de gallium ;
d) graver l'empilement à base de nitrure de gallium en vis-à-vis de ladite région périphérique en utilisant la première couche isolante comme masque de gravure, jusqu'à dévoiler la face supérieure du substrat semiconducteur ;
e) découper le substrat semiconducteur de façon à individualiser les puces électroniques.

Selon un mode de réalisation, le procédé de fabrication, comporte, entre les étapes d) et e), une étape de formation d'une deuxième couche isolante sur la face supérieure de la première couche isolante et dans le fond et sur des flancs latéraux de ladite région périphérique.

Selon un mode de réalisation, la première couche isolante est en un oxyde.

Selon un mode de réalisation, la première couche isolante est déposée lors de l'étape b) avec une épaisseur comprise dans la plage allant de 2 µm à 4 µm.

Selon un mode de réalisation, la structure d'interconnexion a une épaisseur comprise dans la plage allant de 10 µm à 15 µm.

Selon un mode de réalisation, chaque puce électronique comporte un transistor à haute mobilité électronique, le transistor étant formé dans la structure d'interconnexion et dans et sur l'empilement à base de nitrure de gallium.

Selon un mode de réalisation, chaque puce électronique comporte un anneau de scellement.

Selon un mode de réalisation, la structure d'interconnexion comporte un plot métallique, disposé du côté de la face supérieure de la structure d'interconnexion, ledit plot métallique étant recouvert par la première couche isolante lors de l'étape b).

Selon un mode de réalisation, le plot métallique correspond à un plot de reprise de contact du transistor.

Selon un mode de réalisation, la gravure de la première couche isolante et la structure d'interconnexion lors de l'étape c) est une gravure anisotrope et la gravure de l'empilement à base de nitrure de gallium lors de l'étape d) est une gravure anisotrope.

Selon un mode de réalisation, la gravure de la première couche isolante et la structure d'interconnexion lors de l'étape c) est une gravure isotrope et la gravure de l'empilement à base de nitrure de gallium lors de l'étape d) est une gravure anisotrope.

Un autre mode de réalisation prévoit une puce électronique comportant :
- une structure d'interconnexion disposée sur une face supérieure d'un empilement à base de nitrure de gallium, lui-même disposé sur une face supérieure d'un substrat semiconducteur ; et
- une première couche isolante sur la face supérieure de la structure d'interconnexion,
la puce électronique comportant en outre, une ouverture dans une région périphérique, dévoilant la face supérieure du substrat semiconducteur.

Selon un mode de réalisation, dans les ouvertures, les flancs latéraux de la structure d'interconnexion sont alignés avec les flancs latéraux de l'empilement en nitrure de gallium.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C, la figure 1D, la figure 1E, la figure 1F, la figure 1G et la figure 1H sont des vues en coupe, partielles et schématiques, de structures obtenues à l'issue d'étapes successives d'un exemple d'un procédé de fabrication de puces électroniques selon un premier mode de réalisation ;
la figure 2A et la figure 2B sont des vues en coupe, partielles et schématiques, de structures obtenues à l'issue d'étapes successives d'un exemple d'un procédé de fabrication de puces électroniques selon un deuxième mode de réalisation ;
la figure 3A et la figure 3B sont des vues en coupe, partielles et schématiques, de structures obtenues à l'issue d'étapes successives d'un exemple d'un procédé de fabrication de puces électroniques selon un troisième mode de réalisation ; et
la figure 4A et la figure 4B sont des vues en coupe, partielles et schématiques, de structures obtenues à l'issue d'étapes successives d'un exemple d'un procédé de fabrication de puces électroniques selon un quatrième mode de réalisation. Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

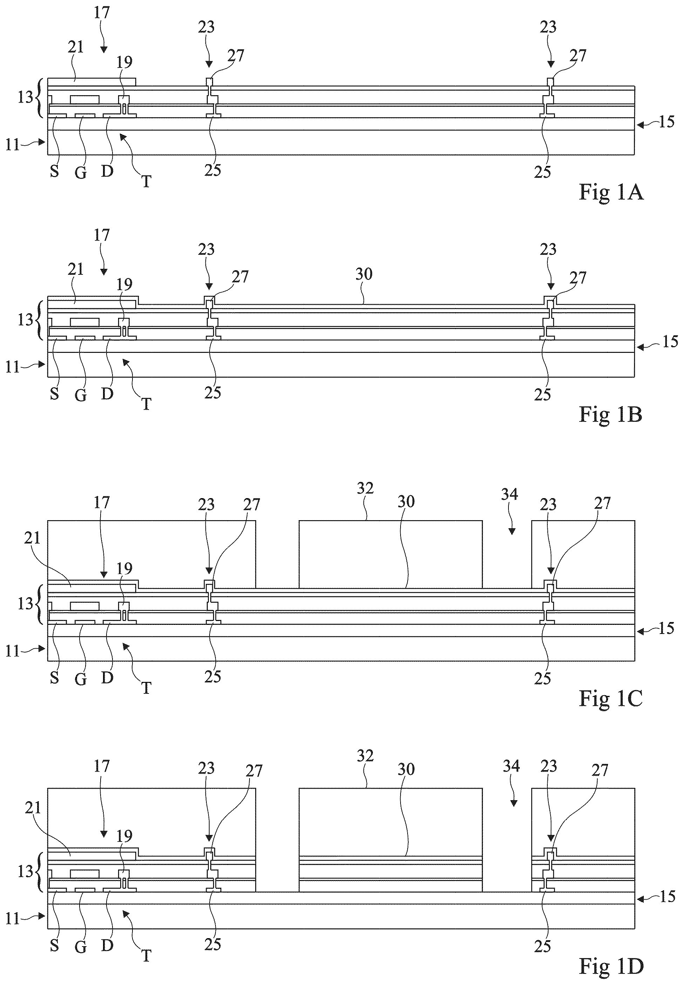

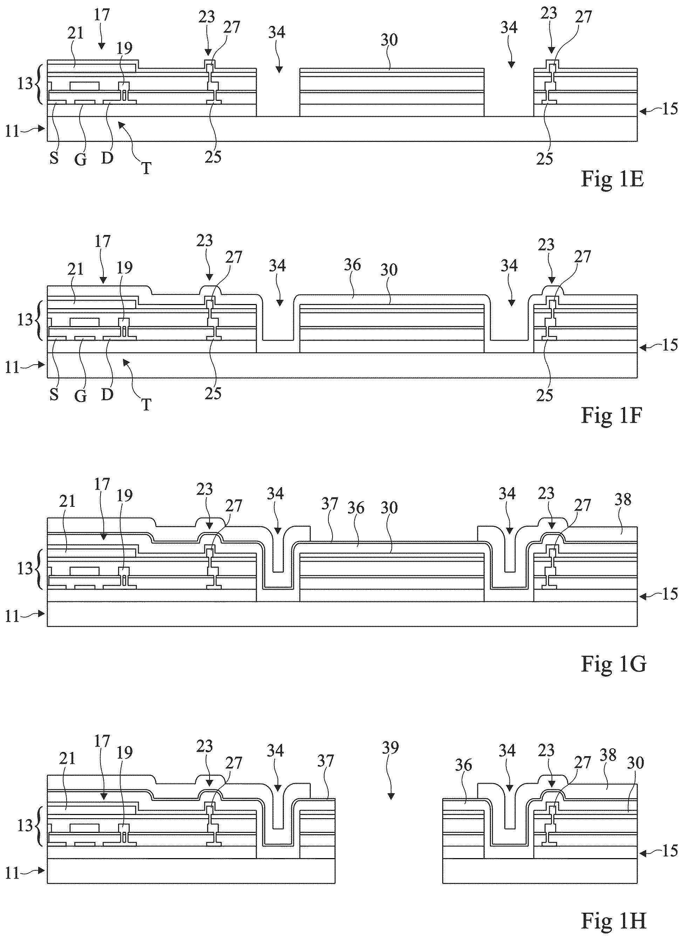

La figure 1A, la figure 1B, la figure 1C, la figure 1D, la figure 1E, la figure 1F, la figure 1G et la figure 1H sont des vues en coupe, partielles et schématiques, de structures obtenues à l'issue d'étapes successives d'un exemple d'un procédé de fabrication de puces électroniques selon un premier mode de réalisation.

La figure 1A illustre une structure de départ comportant, un substrat semiconducteur 11, un empilement à base de nitrure de gallium 15 sur le substrat semiconducteur 11, et une structure d'interconnexion 13 sur l'empilement à base de nitrure de gallium 15. A titre d'exemple, l'empilement à base de nitrure de gallium 15 est disposé sur et en contact avec la face supérieure du substrat semiconducteur 11. L'empilement à base de nitrure de gallium 15 s'étend par exemple de façon continue sur toute la surface supérieure du substrat semiconducteur 11. La structure d'interconnexion est par exemple disposée sur et en contact avec la face supérieure de l'empilement à base de nitrure de gallium 15.

Le substrat 11 est par exemple en silicium, par exemple en silicium monocristallin, ou en carbure de silicium. En variante, le substrat 11 est en nitrure d'aluminium.

L'empilement à base de nitrure de gallium 15 comporte par exemple plusieurs couches semiconductrices. Les couches semiconductrices de l'empilement 15 sont par exemple en des matériaux semiconducteurs de type III-V à base de nitrure de gallium (GaN), par exemple en nitrure de gallium et/ou en nitrure d'aluminium-gallium (AlGaN). L'empilement à base de nitrure de gallium 15 a par exemple une épaisseur comprise dans la plage allant de 2 µm à 10 µm, par exemple de l'ordre de 5 µm.

La structure d'interconnexion 13 correspond par exemple à un empilement de couches isolantes, par exemple diélectriques dans lesquelles sont formées, dans des régions de circuits électroniques 17, des pistes ou plots métalliques. En figure 1A, quatre couches isolantes ont été représentées dans la structure d'interconnexion 13. En pratique, la structure d'interconnexion 13 peut comprendre un nombre de couches isolantes supérieur à quatre. La structure d'interconnexion 13 a par exemple une épaisseur comprise dans la plage allant de 10 µm à 30 µm, par exemple compris dans la plage allant de 15 µm à 18 µm.

A titre d'exemple, la structure de départ comporte une pluralité de régions de circuits 17 formées dans la structure d'interconnexion 13 et l'empilement en GaN 15. En figure 1A, une unique région de circuits 17 a été représentée. Chaque région de circuits 17 peut comprendre une pluralité de composants électriques. A titre d'exemple, chaque région de circuits 17 comporte un transistor T, par exemple un transistor à haute mobilité électronique ou HEMT (de l'anglais « High Electron Mobility Transistor »).

Les transistors T sont par exemple formés dans et sur l'empilement en GaN 15 et dans la structure d'interconnexion 13. A titre d'exemple, chaque transistor T comporte un contact de source S, un contact de drain D et un contact de grille G formés sur l'empilement en GaN 15. A titre d'exemple, ces contacts sont reliés à des pistes ou plots métalliques 19 formés sur et dans les couches isolantes de la structure d'interconnexion 13. A titre d'exemple, la région de circuits 17 comporte un ou plusieurs plots métalliques 21 formés à la surface de la structure d'interconnexion 13. A titre d'exemple, les plots métalliques 21 sont en aluminium, par exemple en aluminium et cuivre.

A titre d'exemple, chaque région de circuits 17 est entourée par un anneau de scellement 23 (« sealring » en anglais) permettant de stopper d'éventuelles fissures se propageant dans la région de circuits 17 et/ou de les détecter. A titre d'exemple, les anneaux de scellement sont formés dans la structure 13. A titre d'exemple, les anneaux de scellement 23 ne s'étendent pas dans l'empilement en GaN 15.

A titre d'exemple, chaque anneau de scellement 23 comporte une pluralité de niveaux métalliques 25, formés sur les couches isolantes de la structure d'interconnexion 13, et reliés entre eux par des vias conducteurs. A titre d'exemple, chaque anneau de scellement comporte en outre un niveau de métallisation supérieur 27 formé à la surface de la structure d'interconnexion 13. A titre d'exemple, les niveaux de métallisation 27 sont en aluminium, par exemple en aluminium et cuivre.

A titre d'exemple, une région de circuits 17 associée à un anneau de scellement 23 qui l'entoure définissent une puce électronique non individualisée et encore solidaire des puces électroniques voisines. A titre d'exemple, dans la structure de départ telle qu'illustrée en figure 1A, les puces électroniques sont solidaires les unes des autres par le substrat 11, l'empilement en GaN 15 et la structure d'interconnexion 13. A titre d'exemple, les puces électroniques n'ont, dans la structure de départ telle qu'illustrée en figure 1A, pas de connexions électriques entre elles.

La figure 1B illustre une structure obtenue à l'issue d'une étape de dépôt d'une couche isolante 30, de masque dur, sur la face supérieure de la structure illustrée en figure 1A.

A titre d'exemple, la couche 30 est déposée sur l'entièreté de la face supérieure de la structure illustrée en figure 1A.

Plus particulièrement, lors de cette étape, la couche 30 est déposée sur et en contact avec la face supérieure de la structure d'interconnexion 13. En outre, lors de cette étape, la couche 30 est par exemple déposée sur la face supérieure des plots 21 et les niveaux 27. A titre d'exemple, lors de cette étape, la couche 30 est déposée en contact avec les plots 21 et les niveaux 27.

La couche 30 est par exemple en un matériau diélectrique, par exemple en un oxyde, par exemple en orthosilicate de tétraéthyle ou TEOS (de l'anglais « Tetraethyl Orthosilicate »).

A titre d'exemple, la couche 30 est déposée de façon conforme, c'est-à-dire qu'elle est déposée avec une épaisseur sensiblement constante sur l'ensemble de sa surface. A titre d'exemple, la couche 30 est déposée avec une épaisseur comprise dans la plage allant de 2 µm à 4 µm, par exemple de l'ordre de 3 µm.

La figure 1C illustre une structure obtenue à l'issue d'une étape de formation d'une couche de masquage en résine 32 sur la face supérieure de la structure illustrée en figure 1B.

Plus particulièrement, lors de cette étape, la couche 32 est formée sur l'entièreté de la face supérieure de la structure illustrée en figure 1B. A titre d'exemple, la couche 32 est formée en contact avec la couche 30.

La couche en résine 32 est par exemple une résine photosensible, par exemple en une résine positive. La couche en résine 32 est par exemple déposée avec une épaisseur comprise dans la plage allant de 10 µm à 15 µm, par exemple de l'ordre de 13 µm.

A titre d'exemple, après son dépôt, la couche en résine 32 est retirée localement par photolithographie en vis-à-vis d'une partie périphérique de chaque puce électronique non individualisée.

La figure 1D illustre une structure obtenue à l'issue d'une étape de gravure de la couche isolante 30 et de la structure d'interconnexion 13 de la structure illustrée en figure 1C à travers la couche de masquage 32.

Plus particulièrement, lors de cette étape, la couche 30 et la structure 13 sont gravées de façon à dévoiler localement la face supérieure de l'empilement en GaN 15.

A titre d'exemple, dans ce mode de réalisation, la gravure de la couche 30 et de la structure 13 correspond à une gravure sèche anisotrope.

Lors de cette étape, la gravure est par exemple une gravure par plasma.

A l'issue de cette étape, la structure comporte des ouvertures 34 formées dans une partie périphérique de chacune des puces électroniques non individualisées. Les ouvertures 34 ont par exemple leurs flancs alignés avec les flancs de la couche de masquage 32 sus-jacente. A titre d'exemple, à l'issue de cette étape, les ouvertures 34 présentent des flancs sensiblement verticaux. A titre d'exemple, à l'issue de cette étape, les ouvertures 34 ont une largeur sensiblement constante sur toute leur profondeur. Les ouvertures 34 ont par exemple une largeur comprise dans la plage allant de 15 µm à 40 µm, par exemple comprise dans la plage allant de 20 µm à 25 µm.

A titre d'exemple, chaque puce comprend une ouverture 34 ayant, en vue de dessus, une forme annulaire entourant entièrement la région de circuits 17 et l'anneau de scellement 23 de la puce.

A l'issue de cette étape, la couche de masquage 32 est par exemple retirée. Après l'étape de retrait de la couche 32, la surface de la couche 30 est par exemple nettoyée.

La figure 1E illustre une structure obtenue à l'issue d'une étape de gravure de l'empilement en nitrure de gallium 15 de la structure illustrée en figure 1D à travers la couche isolante de masquage 30. Lors de cette étape, la couche 30 sert de masque de gravure à l'empilement 15.

Plus particulièrement, lors de cette étape, l'empilement 15 est gravé de façon à dévoiler localement la face supérieure du substrat 11.

A titre d'exemple, dans ce mode de réalisation, la gravure de l'empilement 15 correspond à une gravure sèche anisotrope.

Lors de cette étape, la gravure est par exemple une gravure par plasma.

A l'issue de cette étape, les ouvertures 34 formées lors de l'étape de gravure sont prolongées verticalement dans l'empilement 15 jusqu'à la face supérieure du substrat 11. Les ouvertures 34 sont également appelées TGV, de l'anglais « Through GaN Via » - via traversant le GaN, dans la mesure où elles traversent verticalement l'empilement 15 à base de GaN.

A titre d'exemple, à l'issue de cette étape, les ouvertures présentent des flancs rectilignes sur l'ensemble de leur hauteur. A titre d'exemple, les ouvertures 34 n'ont ainsi pas de « marche » sur leurs flancs latéraux entre l'empilement 15 et la structure d'interconnexion 13. Les ouvertures 34 ont alors la même largeur dans le plan de la face supérieure de la structure d'interconnexion 13 que dans le plan de la face inférieure de l'empilement en GaN 15.

A titre d'exemple, la couche 30 est partiellement consommée lors de la gravure de l'empilement en GaN 15. Ainsi, à l'issue de cette étape, la couche 30 a par exemple une épaisseur restante comprise dans la plage allant de 0,5 µm à 3 µm, par exemple de l'ordre de 1 µm.

La figure 1F illustre une structure obtenue à l'issue d'une étape de dépôt d'une autre couche isolante 36 sur la face supérieure de la structure illustrée en figure 1E.

Plus particulièrement, lors de cette étape, la couche 36 est formée sur la face supérieure de la couche 30 et dans le fond et sur les flancs des ouvertures 34.

Lors de cette étape, la couche 36 est formée en contact avec la face supérieure de la couche 30. Lors de cette étape, la couche 36 est de plus en contact avec les flancs de la structure d'interconnexion 13 et la couche 30 dans les ouvertures 34. Lors de cette étape, la couche 36 est en outre en contact avec la face supérieure du substrat 11 dans les ouvertures 34.

La couche 36 est par exemple une couche en un matériau diélectrique. A titre d'exemple, la couche 36 est en un oxyde, par exemple en TEOS. En variante, la couche 36 est en dioxyde de silicium et en nitrure de silicium.

A titre d'exemple, la couche 36 est déposée avec une épaisseur comprise dans la plage allant de 2 µm à 10 µm, par exemple de l'ordre de 5 µm.

La figure 1G illustre une structure obtenue à l'issue d'une étape de formation d'une couche en un matériau diélectrique 37 et d'une couche d'encapsulation 38 sur la face supérieure de la structure illustrée en figure 1F.

Plus particulièrement, lors de cette étape, on vient former dans un premier temps la couche en le matériau diélectrique 37 sur la face supérieure de la structure illustrée en figure 1F et plus précisément sur la face supérieure de la couche 36.

A titre d'exemple, la couche en le matériau diélectrique 37 est en nitrure, par exemple en nitrure de silicium.

A titre d'exemple, la couche en le matériau diélectrique 37 a une épaisseur inférieure à 1,5 µm, par exemple inférieure à 1 µm.

Dans un second temps, on vient former la couche d'encapsulation 38 sur la face supérieure de la couche en le diélectrique 37. La couche 38 recouvre ainsi la couche 37 sur l'ensemble de la structure et notamment dans les ouvertures 34.

A titre d'exemple, la couche d'encapsulation 38 est en un matériau diélectrique dit d'encapsulation à faible température ou LTC (de l'anglais « Low Temperature Coating »). A titre d'exemple, la couche d'encapsulation 38 est en polyamide, par exemple en polyimide.

A titre d'exemple, la couche 38 est déposée avec une épaisseur comprise dans la plage allant de 5 µm à 15 µm, par exemple de l'ordre de 7 µm.

A titre d'exemple, à l'issue du dépôt de la couche 38, celle-ci ainsi que les couches 30 et 36 sont retirées localement en vis-à-vis de certains plots métalliques 21 afin de permettre la reprise du contact électrique sur ces mêmes plots. En outre, la couche d'encapsulation 38 est retirée dans une portion entre les ouvertures 34 périphériques réalisées autour de puces voisines, en vis-à-vis des futurs chemins de découpe individualisant les puces.

A titre d'exemple, à l'issue de ces étapes de dépôt et retrait, une couche métallique (non représentée) est déposée sur la face supérieure de la structure, c'est-à-dire sur la couche d'encapsulation 38 et dans les ouvertures débouchant sur les plots métalliques 21. A titre d'exemple, la couche métallique est en aluminium, par exemple en aluminium et cuivre.

La figure 1H illustre une structure obtenue à l'issue d'une étape de découpage de la structure illustrée en figure 1G de façon à former des puces électroniques individuelles.

Plus particulièrement, lors de cette étape on vient créer des chemins de découpe 39 entre chacune des puces non individualisées. Plus précisément, lors de cette étape, on vient créer des chemins de découpe 39 entre les ouvertures 34 périphériques réalisées autour de puces voisines.

A titre d'exemple, les chemins de découpe 39 sont réalisés par sciage. En variante, les chemins de découpe 39 sont réalisés par découpe laser.

Un avantage du présent mode de réalisation est que les ouvertures 34 forment un anneau de scellement supplémentaire permettant d'éviter ou de limiter la propagation de fissures dans la structure d'interconnexion et dans l'empilement en GaN.

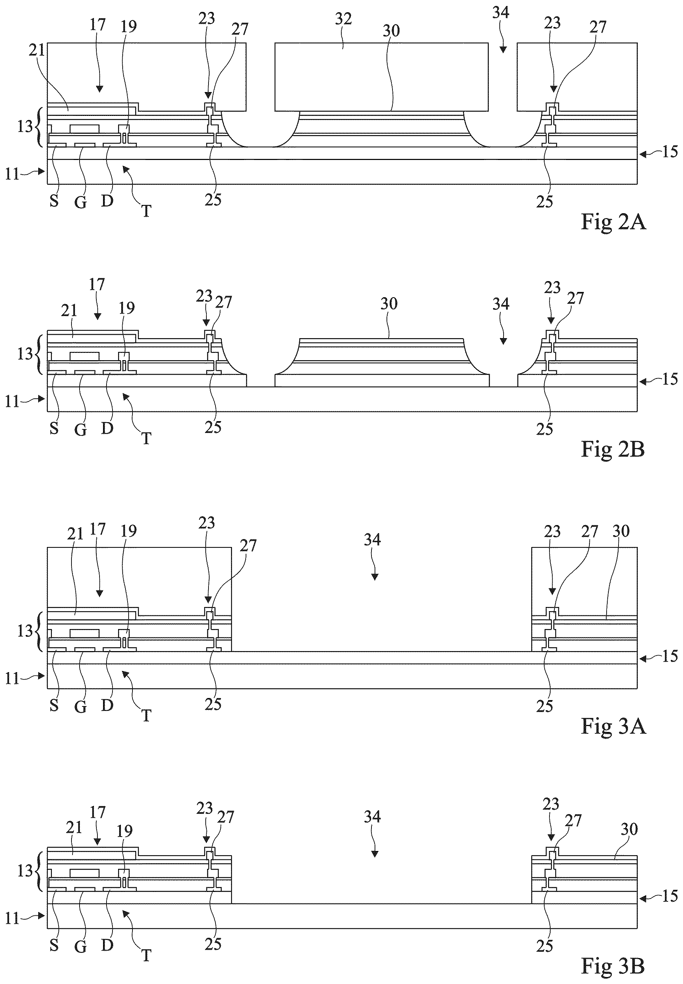

La figure 2A et la figure 2B sont des vues en coupe, partielles et schématiques, de structures obtenues à l'issue d'étapes successives d'un exemple d'un procédé de fabrication de puces électroniques selon un deuxième mode de réalisation.

Le procédé de fabrication des puces électroniques selon le deuxième mode de réalisation est similaire au procédé de fabrication des puces électroniques selon le premier mode de réalisation à la différence près que, dans le deuxième mode de réalisation, l'étape de gravure de la couche 30 et de la structure d'interconnexion 13 est une gravure isotrope. L'étape de gravure de l'empilement en GaN 15 est quant à elle une gravure anisotrope.

Le procédé de fabrication d'une puce électronique selon le deuxième mode de réalisation comprend les étapes décrites en relation avec les figures 1A à 1C à l'identique, ces dernières ne seront ainsi par redécrites ci-après.

La figure 2A illustre une structure obtenue à l'issue d'une étape de gravure isotrope de la couche isolante 30 et de la structure d'interconnexion 13 de la structure illustrée en figure 1C à travers la couche en résine 32.

Plus particulièrement, lors de cette étape, la couche 30 et la structure 13 sont gravées de façon à dévoiler localement la face supérieure de l'empilement en GaN 15.

Lors de cette étape, la gravure est par exemple une gravure humide.

En variante, la gravure est lors de cette étape une gravure sèche, par exemple une gravure par plasma.

A l'issue de cette étape, la structure comporte des ouvertures 34 formées dans une partie périphérique de chacune des puces électroniques non individualisées. Les ouvertures 34 ont par exemple leurs flancs arrondis ou obliques. Dans l'exemple de la figure 2A, du fait de l'isotropie de la gravure, le sommet des flancs des ouvertures 34 n'est pas aligné avec les flancs de la couche de masquage 32. Dans cet exemple, chaque ouverture 34 s'étend en partie sous la couche de masquage 32. A titre d'exemple, à l'issue de cette étape, les ouvertures 34 ont une largeur diminuant à partir de la face supérieure de la couche 30 jusqu'à la face inférieure de la structure 13. C'est-à-dire que les ouvertures ont une largeur prise dans le plan de la face supérieure de la couche 30 supérieure par rapport à leur largeur prise dans le plan de la face inférieure de la structure d'interconnexion 13.

A l'issue de cette étape, la couche de masquage 32 est par exemple retirée. Après l'étape de retrait de la couche 32, la surface de la couche 30 est par exemple nettoyée.

La figure 2B illustre une structure obtenue à l'issue d'une étape de gravure de l'empilement en nitrure de gallium 15 de la structure illustrée en figure 2B à travers la couche isolante 30.

Plus particulièrement, lors de cette étape, l'empilement 15 est gravé de façon à dévoiler localement la face supérieure du substrat 11.

A titre d'exemple, dans ce mode de réalisation, la gravure de l'empilement 15 correspond à une gravure anisotrope.

Lors de cette étape, la gravure est par exemple une gravure sèche.

A l'issue de cette étape, les ouvertures 34 formées lors de l'étape de gravure s'étendent dorénavant dans l'empilement 15 jusqu'à la face supérieure du substrat 11.

A titre d'exemple, à l'issue de cette étape, la partie inférieure de chaque ouverture 34 présente des flancs rectilignes verticaux sur l'ensemble de sa hauteur. A titre d'exemple, à l'issue de cette étape, la largeur des ouvertures 34 est, à travers l'empilement 15, sensiblement constante. C'est-à-dire que la largeur des ouvertures 34 prise dans le plan de la face supérieure de l'empilement 15 est sensiblement égale à la largeur des ouvertures 34 prise dans le plan de la face inférieure de l'empilement 15.

A titre d'exemple, la couche 30 est légèrement consommée lors de la gravure de l'empilement en GaN 15. Ainsi, à l'issue de cette étape, la couche 30 a par exemple une épaisseur résultante comprise dans la plage allant de 0,5 µm à 3 µm, par exemple de l'ordre de 1 µm.

Après l'étape de gravure de l'empilement en nitrure de gallium 15, le procédé se poursuit par les étapes décrites en relation avec les figures 1F à 1H. Ces étapes sont similaires à ce qui a été décrit dans le premier mode de réalisation à la différence près de la géométrie des ouvertures 34.

La figure 3A et la figure 3B sont des vues en coupe, partielles et schématiques, de structures obtenues à l'issue d'étapes successives d'un exemple d'un procédé de fabrication de puces électroniques selon un troisième mode de réalisation.

Le procédé de fabrication des puces électroniques selon le troisième mode de réalisation est similaire au procédé de fabrication des puces électroniques selon le premier mode de réalisation à la différence près que, dans le troisième mode de réalisation, les ouvertures 34 ont une largeur plus importante de sorte que le chemin de découpe 39 d'individualisation des puces passe dans les ouvertures 34.

Le procédé de fabrication d'une puce électronique selon le troisième mode de réalisation comprend les étapes décrites en relation avec les figures 1A à 1C à l'identique, ces dernières ne seront ainsi par redécrites ci-après.

La figure 3A illustre une structure obtenue à l'issue d'une étape de gravure de la couche isolante 30 et de l'empilement d'interconnexion 13 de la structure illustrée en figure 1C à travers la couche en résine 32.

Cette étape est similaire à celles illustrées en figures 1C et 1D à la différence près que les ouvertures 34 ne sont pas formées dans une partie périphérique de chacune des puces électroniques non individualisées mais qu'elles sont formées entre chacune des puces électroniques non individualisées et que les ouvertures s'étendent d'une partie périphérique d'une puce électronique jusqu'à la partie périphérique de la puce électronique voisine.

La figure 3B illustre une structure obtenue à l'issue d'une étape de gravure de l'empilement en nitrure de gallium 15 de la structure illustrée en figure 3A à travers la couche isolante 30.

Cette étape est identique à l'étape de gravure illustrée en figure 1E.

Après l'étape de gravure de l'empilement en nitrure de gallium 15, le procédé se poursuit par les étapes décrites en relation avec les figures 1F à 1H. Ces étapes sont similaires à ce qui a été décrit dans le premier mode de réalisation à la différence près de la géométrie des ouvertures 34. Dans ce mode de réalisation, le chemin de découpe 39 d'individualisation des puces électroniques est alors formé dans les ouvertures 34.

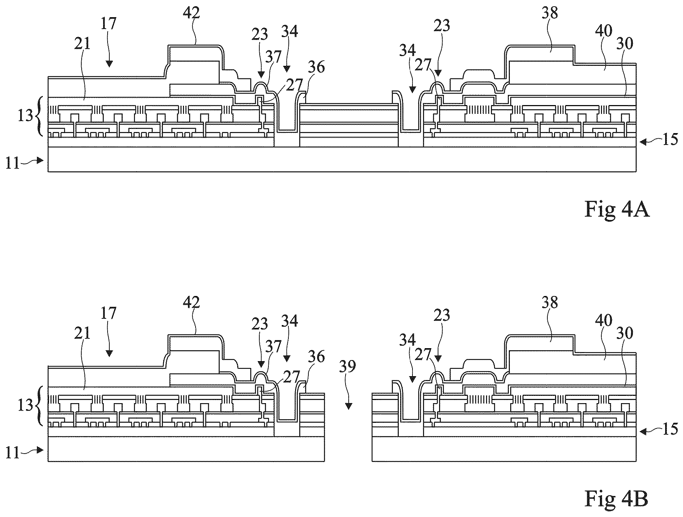

La figure 4A et la figure 4B sont des vues en coupe, partielles et schématiques, de structures obtenues à l'issue d'étapes successives d'un exemple d'un procédé de fabrication de puces électroniques selon un quatrième mode de réalisation.

Le procédé de fabrication des puces électroniques selon le quatrième mode de réalisation est similaire au procédé de fabrication des puces électroniques selon le premier mode de réalisation à la différence près que, dans le quatrième mode de réalisation, le procédé comprend, avant la formation de la couche d'encapsulation 38, la formation d'une couche métallique 40 sur la face supérieure de la couche en nitrure 37 formée à la surface de la couche isolante 36.

Le procédé de fabrication d'une puce électronique selon le quatrième mode de réalisation comprend les étapes décrites en relation avec les figures 1A à 1F à l'identique, ces dernières ne seront ainsi par redécrites ci-après.

La figure 4A illustre une structure obtenue à l'issue d'une étape de dépôt de la couche en nitrure 37, de la couche métallique 40 et de la couche d'encapsulation 38 sur la face supérieure de la structure illustrée en figure 1F.

A titre d'exemple, avant le dépôt de la couche métallique 40, les couches 30 et 36 peuvent être retirées localement en vis-à-vis des plots métallique 21 de façon à exposer la face supérieure des plots métalliques 21 et garantir la formation de la couche métallique 40 sur et en contact avec les plots 21.

Après son dépôt, la couche métallique 40 est par exemple retirée localement de façon à n'être conservée qu'aux endroit souhaités pour la connexion à un ou des dispositifs extérieurs.

La couche métallique 40 est par exemple en cuivre.

En outre, la structure illustrée en figure 4A comprend un bossage métallique 42 ou UBM (de l'anglais « Under Bump Metallization »). Le bossage 42 est par exemple formé sur et en contact avec la couche métallique 40. Le bossage métallique 42 est par exemple à base de titane, de nickel, d'argent et/ou d'or. A l'issue de cette étape, la couche 38 est par exemple formée sur, et par exemple en contact avec, la couche métallique 40. A titre d'exemple, la couche 38 est retirée des ouvertures 34. En outre, la couche 38 peut être retirée dans une portion entre les ouvertures 34 périphériques réalisées autour de puces voisines, en vis-à-vis des futurs chemins de découpe individualisant les puces.

La figure 4B illustre une structure obtenue à l'issue d'une étape de sciage de la structure illustrée en figure 4A de façon à former des puces électroniques individuelles.

Cette étape est identique à celle décrite en relation avec la figure 1H. La couche d'encapsulation 38 est par exemple retirée localement de façon à laisser la face supérieure de la couche métallique 40 dévoilée.

De nombreuses applications sont susceptibles de tirer profit des avantages procurés par la puce électronique, cette puce pouvant ainsi être intégrée dans divers types de composants.

À titre d'exemple, la puce électronique peut être intégrée dans un composant destiné à l'industrie automobile. L'électrification des véhicules automobiles cause une forte augmentation du nombre de composants électroniques présents dans les véhicules. Le composant comprend par exemple des thyristors, des redresseurs, des diodes de suppression de tensions transitoires, des modules, etc. destinés à être incorporés dans les dits véhicules. Par ailleurs, l'aide à la conduite et l'automatisation de la conduite sont à l'origine d'une augmentation du nombre de composants électroniques dans les véhicules.

À titre d'exemple, la puce électronique peut être intégrée dans un composant destiné à l'industrie. En particulier, le composant est par exemple utilisé pour le développement des énergies vertes ou pour l'électrification d'infrastructures, par exemple pour des bornes de recharge ou pour la collecte d'énergie solaire. Le composant peut également être utilisé dans le domaine de l'internet des objets ou dans le domaine des maisons connectées. Le composant est par exemple destiné à être mis en œuvre dans des circuits d'alimentation en énergie électrique d'équipements, comprenant par exemple des transistors de 30 V à 1200 V. Le composant peut également être utilisé pour la mise en œuvre de systèmes d'informatique dans le nuage, de réseaux de communication radiofréquence 5G, de centres de données et de serveurs. Le composant comprend par exemple des matériaux à large bande interdite.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les deuxième et quatrième modes de réalisation et les troisième et quatrième modes de réalisation peuvent être combinés.

Par ailleurs, les modes de réalisation ne se limitent pas aux exemples de valeurs numériques ni aux exemples de matériaux mentionnés dans la présente description.

Enfin, la mise en oeuvre pratique des modes de réalisation et variantes décrits est à la portée de la personne du métier à partir des indications fonctionnelles données ci-dessus.

## Revendications

1. Procédé de fabrication de puces électroniques comportant les étapes successives suivantes :
a) former une structure d'interconnexion (13) sur une face supérieure d'un empilement à base de nitrure de gallium (15), lui-même disposé sur une face supérieure d'un substrat semiconducteur (11) ;
b) disposer une première couche isolante (30) sur la face supérieure de la structure d'interconnexion (13) ;
c) former un masque de gravure en résine (32) sur la face supérieure de la première couche isolante (30) puis graver la première couche isolante (30) et la structure d'interconnexion (13) à travers le masque de gravure en résine (32) dans une région périphérique de chaque puce électronique jusqu'à dévoiler la face supérieure de l'empilement à base de nitrure de gallium (15) ;
d) graver l'empilement à base de nitrure de gallium (15) en vis-à-vis de ladite région périphérique en utilisant la première couche isolante (30) comme masque de gravure, jusqu'à dévoiler la face supérieure du substrat semiconducteur (11) ;
e) découper le substrat semiconducteur (11) de façon à individualiser les puces électroniques.

2. Procédé de fabrication selon la revendication 1, comportant, entre les étapes d) et e), une étape de formation d'une deuxième couche isolante (36) sur la face supérieure de la première couche isolante (30) et dans le fond et sur des flancs latéraux de ladite région périphérique.

3. Procédé de fabrication selon la revendication 1 ou 2, dans lequel la première couche isolante (30) est en un oxyde.

4. Procédé de fabrication selon l'une quelconque des revendications 1 à 3, dans lequel la première couche isolante (30) est déposée lors de l'étape b) avec une épaisseur comprise dans la plage allant de 2 µm à 4 µm.

5. Procédé de fabrication selon l'une quelconque des revendications 1 à 4, dans lequel la structure d'interconnexion (13) a une épaisseur comprise dans la plage allant de 10 µm à 15 µm.

6. Procédé de fabrication selon l'une quelconque des revendications 1 à 5, dans lequel chaque puce électronique comporte un transistor à haute mobilité électronique, le transistor étant formé dans la structure d'interconnexion (13) et dans et sur l'empilement à base de nitrure de gallium (15).

7. Procédé de fabrication selon l'une quelconque des revendications 1 à 6, dans lequel chaque puce électronique comporte un anneau de scellement.

8. Procédé selon l'une quelconque des revendications 1 à 7, dans lequel la structure d'interconnexion (13) comporte un plot métallique (21), disposé du côté de la face supérieure de la structure d'interconnexion (13), ledit plot métallique (21) étant recouvert par la première couche isolante (30) lors de l'étape b).

9. Procédé selon la revendication 8 dans sa dépendance à la revendication 6, dans lequel le plot métallique (21) correspond à un plot de reprise de contact du transistor.

10. Procédé selon l'une quelconque des revendications 1 à 9, dans lequel la gravure de la première couche isolante (30) et la structure d'interconnexion (13) lors de l'étape c) est une gravure anisotrope et la gravure de l'empilement à base de nitrure de gallium (15) lors de l'étape d) est une gravure anisotrope.

11. Procédé selon l'une quelconque des revendications 1 à 9, dans lequel la gravure de la première couche isolante (30) et la structure d'interconnexion (13) lors de l'étape c) est une gravure isotrope et la gravure de l'empilement à base de nitrure de gallium (15) lors de l'étape d) est une gravure anisotrope.

12. Puce électronique fabriquée selon l'une quelconque des revendications 1 à 11, comportant :
une structure d'interconnexion (13) disposée sur une face supérieure d'un empilement à base de nitrure de gallium (15), lui-même disposé sur une face supérieure d'un substrat semiconducteur (11) ; et
- une première couche isolante (30) sur la face supérieure de la structure d'interconnexion (13),
la puce électronique comportant en outre, une ouverture (34) dans une région périphérique, dévoilant la face supérieure du substrat semiconducteur (11).

13. Puce électronique selon la revendication 12, dans laquelle, dans les ouvertures (34), les flancs latéraux de la structure d'interconnexion (13) sont alignés avec les flancs latéraux de l'empilement en nitrure de gallium (15).
